# EUROPEAN PATENT SPECIFICATION

(11) **EP 2 278 350 B1**
(45) Date of publication and mention of the grant of the patent: **28.03.2012**
(21) Application number: 10169288.7
(22) Date of filing: 12.07.2010
(51) Int. Cl.: G01R 33/00, G01R 33/09

(54) **Magnetic sensor and method for manufacturing magnetic sensor**
Magnetischer Sensor und Verfahren zur Herstellung eines magnetischen Sensors
Capteur magnétique et procédé de fabrication d'un capteur magnétique

(30) Priority: 23.07.2009 JP 2009172012
(43) Date of publication of application: 26.01.2011
(73) Proprietor: Kabushiki Kaisha Tokai Rika Denki Seisakusho, Ohguchi-cho Niwa-gun Aichi 480-0195 (JP)
(72) Inventor: Ishizaki, Yoichi, Aichi Japan Aichi 480-0195 (JP)
(74) Representative: Sherrard-Smith, Hugh

(56) References cited:
- US-A1- 2006 127 701
- US-A1- 2008 169 807

## Description

This application is based upon and claims the benefit of priority from prior Japanese Patent Application No. 2009-172012, filed on July 23, 2009, the entire contents of which are incorporated herein by reference.

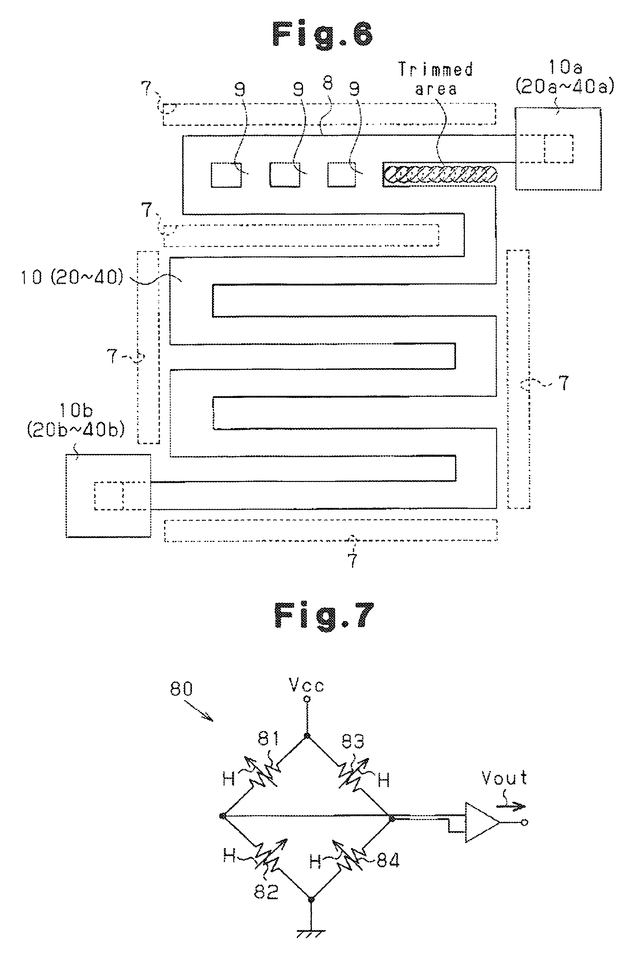

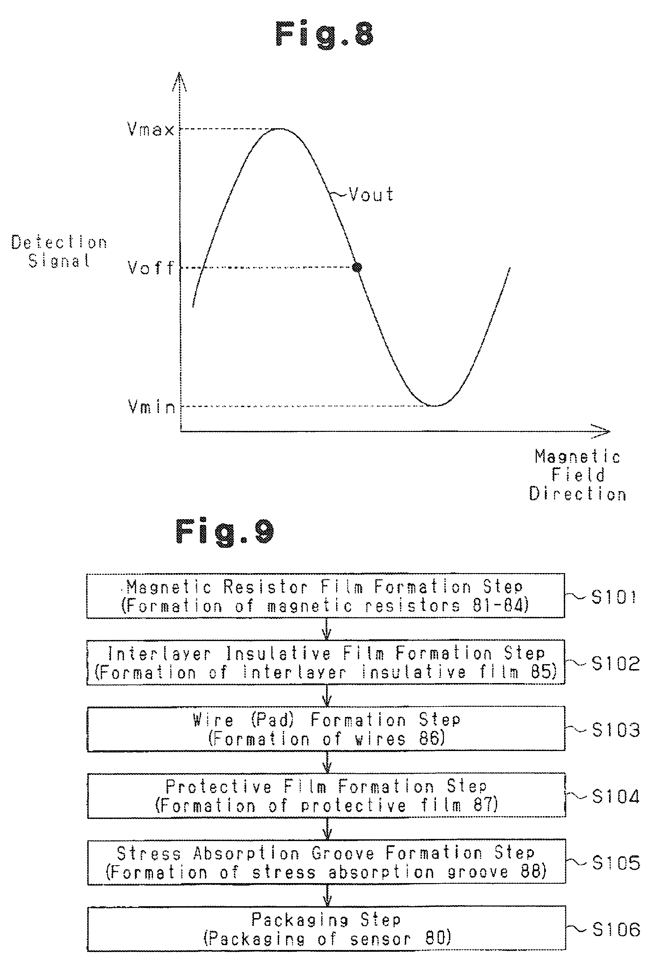

The present invention relates to a magnetic sensor that outputs a signal in accordance with a detection of magnetic field and a method for manufacturing a magnetic sensor.
A magnetic sensor detects the position or variation amount of a detection subject from changes in a magnetic field. Referring to Fig. 7, a typical magnetic sensor 80 includes a bridge circuit formed by four magnetic resistors 81 to 84. In the bridge circuit, power supply voltage Vcc is applied to the series circuit of the magnetic resistors 81 and 82 and the series circuit of the magnetic resistors 83 and 84. The resistance of the magnetic resistors 81 to 84 varies in accordance with changes in the magnetic field. The magnetic sensor outputs the difference of the voltage at a node between the magnetic resistors 81 and 82 and the voltage at a node between the magnetic resistors 83 and 84 as a detection signal Vout.
Referring to Fig. 8, the detection signal from the magnetic sensor 80 varies between a maximum output Vmax and a minimum output Vmin. A median value of the maximum output Vmax and the minimum output Vmin may be referred to as an offset voltage Voff of the magnetic sensor 80 (Voff=(Vmax+Vmin)/2). Generally, the detection accuracy of the magnetic sensor 80 increases as the offset voltage Voff becomes closer to "0". To approximate the offset voltage Voff to "0", the resistances of the magnetic resistors must be adjusted so that the resistances R1, R2, R3, and R4 of the magnetic resistors 81, 82, 83, and 84 satisfy the relationship of "R1xR4=R2XR3".
Fig. 9 shows how the magnetic sensor 80 is manufactured in the prior art. The manufacturing includes a film of formation step S101 for forming the magnetic resistors 81 to 84, a film formation step S102 for forming an interlayer insulative film 85 that covers the upper surfaces of the magnetic resistors 81 to 84, a formation step S103 for electrically connecting wires 86 (and metal pads) to the magnetic resistors 81 to 84, a film formation step S104 for forming a protective film 87 that covers the upper surfaces of the magnetic resistors 81 to 84, a step 105 for forming a stress absorption groove 88 by etching the protective film 87, and a step S106 for packaging the magnetic sensor 80.
The protective film 87 may be formed on a substrate 90 by performing chemical vapour deposition (CVD) or the like. The protective film 87, when formed, may receive strain that remains as residual stress. The residual stress may change the resistances of the magnetic resistors 81 to 84 and cause variations in the offset voltage. The inventor of the present invention has proposed the formation of the stress absorption groove 88 subsequent to the formation of the protective film 87 to absorb the residual stress of the protective film 87 with the groove 88 (refer to Japanese Laid-Open Patent Publication Nos. 2007-333587 and 2007-46920).

In the packaging step, heated resin is applied to the surface of the protective film 87 and then solidified. This heats the magnetic resistors 81 to 84 during the packaging step. Thus, even when the protective film 87 includes the stress absorption groove 88 to minimize variations in the offset voltage Voff, the influence of the heat on the magnetic resistors 81 to 84 during the packaging step results in the tendency for the offset voltage Voff to vary.

US 2008/0169807 discloses a small-size magnetic sensor for detecting the intensity of a magnetic field in three axial directions, in which a plurality of giant magnetoresistive elements are formed on a single semiconductor substrate. A thick film is formed on the semiconductor substrate; giant magnetoresistive elements forming an X-axis sensor and a Y-axis sensor are formed on a planar surface thereof: and giant magnetoresistive elements forming a Z-axis sensor are formed using slopes of channels formed in the thick film. Regarding the channel formation, it is possible to use the reactive ion etching and high-density plasma CVD methods. In addition, an insulating film is formed between the thick film and passivation film and is used as an etching stopper. Each of the slopes of the channels can be constituted of a first slope and a second slope, so that a magneto-sensitive element is formed on the second slope having a larger inclination angle.

US 2006/0127701 discloses a method of manufacturing a device with a magnetic layer-structure, the method comprising the steps of: forming the magnetic layer-structure (2), heating the magnetic layer-structure with an electric current, wherein the electric current is a pulse (3) having a duration such that no substantial heat transfer from the layer-structure to the environment (4) of the layer-structure takes place, so that the temperature of said environment before and after the current pulse is substantially the same.

One aspect of the present invention is a method for manufacturing a magnetic sensor. The method includes forming a plurality of magnetic detection elements on a substrate to form a bridge circuit, forming a protective film that covers and protects the magnetic detection elements on the substrate, forming a plurality of stress absorption grooves in the protective film near each of the magnetic detection elements by etching the protective film to produce a multilayer substrate by forming a packaging mold that covers the entire surface of the multi layer substrate to define the outer shape fo the magnetic sensor, and annealing the multilayer substrate prior to the packaging.
Other aspects and advantages of the present invention will become apparent from the following description, taken in conjunction with the accompanying drawings, illustrating by way of example the principles of the invention.

The invention, together with objects and advantage thereof, may best be understood by reference to the following description of the preferred embodiments together with the accompanying drawings in which:
Fig. 1 is a schematic plan view showing a preferred embodiment of a magnetic sensor;
Fig. 2 is a partial cross-sectional view of the magnetic sensor shown in Fig. 1;
Fig. 3 is a plan view of a magnetic resistor that has undergone trimming;
Fig. 4 is a flowchart showing a process for manufacturing the magnetic sensor;
Fig. 5 is a graph showing offset voltage variations in the preferred embodiment and in the prior art;
Fig. 6 is a plan view showing a further example of a magnetic resistor;
Fig. 7 is an equivalent circuit diagram of a magnetic sensor;
Fig. 8 is a waveform chart showing a detection signal from the magnetic sensor;
Fig. 9 is a flowchart showing a process for manufacturing a magnetic sensor in the prior art; and

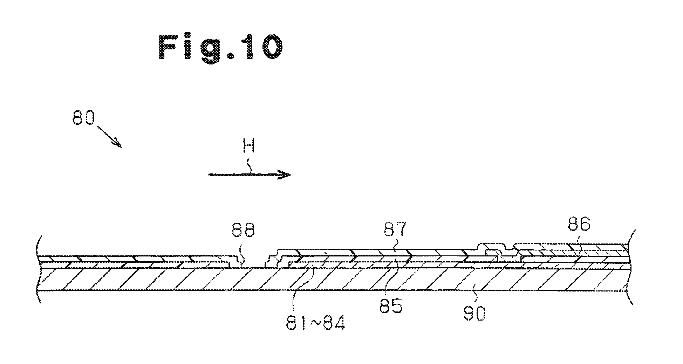

Fig. 10 is a cross-sectional view of a magnetic sensor.

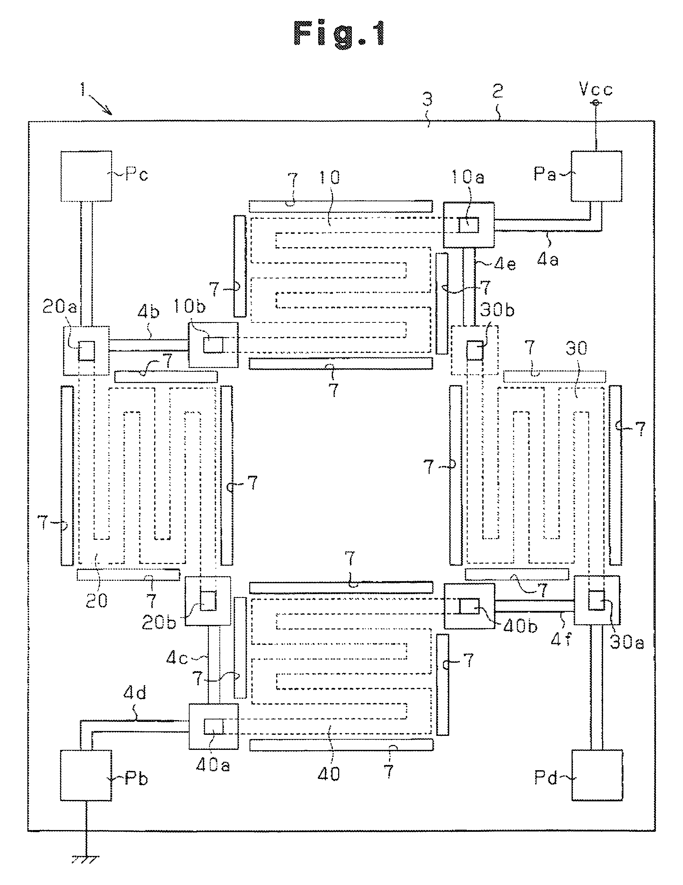

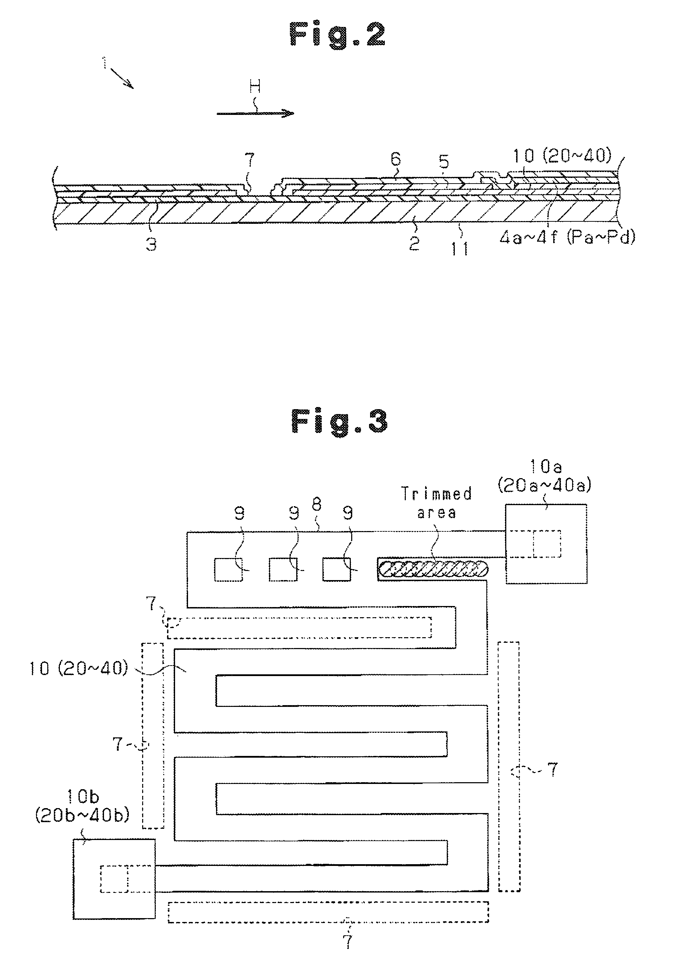

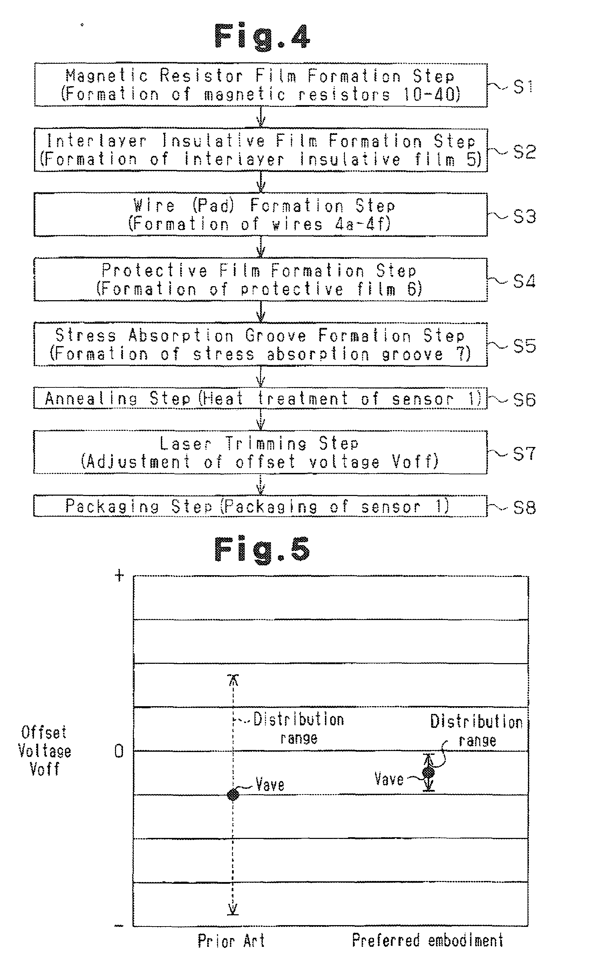

A preferred embodiment of a magnetic sensor and a method for manufacturing the magnetic sensor will now be discussed with reference to Figs. 1 to 5.
Referring to Figs. 1 and 2, a magnetic sensor 1 is a magnetic resistance element (MRE) sensor that detects the direction of a magnetic field H (refer to Fig. 2) acting on the magnetic sensor 1 with a plurality (for example, four) magnetic resistors 10, 20, 30 and 40 and outputs a signal in accordance with the detected magnetic field direction. The magnetic sensor 1 includes various types of components arranged on, for example, a silicon substrate 2 (refer to Fig. 2). An insulative film 3 formed from, for example, an oxide film, is arranged on the entire surface of the substrate 2. The insulative film 3 insulates the substrate 2 from the magnetic resistors 10 to 40. The insulative film 3 functions as an underlayer film for the magnetic resistors 10 to 40. The magnetic resistors 10 to 40 are examples of magnetic detection elements.
As shown in Fig. 1, the four magnetic resistors 10 to 40 are arranged at four locations on the surface of the insulative film 3. The magnetic resistors 10 to 40 are each formed by a repetitively meandered sensor element and thereby zigzagged. The magnetic resistors 10 to 40 are each included by ninety degrees relative to the adjacent resistor. In the illustrated example, the first and fourth magnetic resistors 10 to 40 face toward each other, and the second and third magnetic resistors 20 and 30 face toward each other.
Wires 4a-4f electrically connect the magnetic resistors 10 to 40 on the substrate 2 to form a bridge circuit. The magnetic resistors 10 to 40 form two series circuits connected between the power supply Vcc and the GND, with each series circuit including two adjacent magnetic resistors. More specifically, the first magnetic resistor 10 has one terminal 10a, which is connected to the power supply Vcc by the wire 4a and a metal pad pa, and another terminal 10b, which is connected to one terminal 20a of the second magnetic resistor 20 by a wire 4b. The second magnetic resistor 20 has another terminal 20b connected to GND via wires 4c and 4d and a metal pad Pb. The third magnetic resistor 30 has one terminal 30b, which is connected to the power supply Vcc by wires 4e and 4a and the metal pad Pa, and another terminal 30a, which is connected to one terminal 40b of the fourth magnetic resistor 40 by a Wire 4f. The fourth magnetic resistor 40 has another terminal 40a connected to GND via the wire 4d and the metal pad Pb. A node (terminal 20a) between the magnetic resistors 10 and 20 is connected to a metal pad Pc. A node (terminal 30a) between the magnetic resistors 30 and 40 is connected to a metal pad Pd.
When a magnetic field acts on the magnetic sensor 1, magnetic fields H of the same direction act on the first and fourth magnetic resistors 10 and 40, and magnetic fields H of the same direction act on the second and third magnetic resistors 20 and 30. The magnetic sensor 1 outputs a detection signal, which is the difference of the voltage at the node between the first and second magnetic resistors 10 and 20 and the voltage at the node between the third and fourth magnetic resistors 30 and 40.
As shown in Fig. 2, an interlayer insulative film 5 is arranged on the upper surfaces of the magnetic resistors 10 to 40 to protect the magnetic resistors 1 to 40. The interlayer insulative film 5 keeps the parasitic capacitance low on the substrate 2 and may be formed by, for example, a nitride film. In the illustrated example, the Interlayer insulative film 5 is arranged between the magnetic resistors 10 to 40 and the wires 4a to 4f (metal pads Pa to Pd) except at portions corresponding to the terminals 10a to 40a.
The protective film 6 covers the entire surface of the interlayer insulative film 5. The protective film 6 is referred to as a passivation film and may be formed by, for example, a nitride film.
A plurality of stress absorption grooves 7 are formed at predetermined locations near each of the magnetic resistors 10 to 40. The stress absorption grooves 7 prevent residual stress of the protective film 6, which is caused by strain, from varying the characteristics of the magnetic resistors 10 to 40. The stress absorption grooves 7 are formed by etching the protective film 6 and partially removing the protective Film 6. In the illustrated example, the etching partially removes the interlayer insulative film 5 in addition to the protective film 6.
in the example of Fig. 3, four stress absorption grooves 7 are formed for each magnetic resistor. The magnetic resistors 10 to 40 each include a sensor element, which is meandered and zigzagged so as to have a tetragonal outer shape, and a rough adjustment portion 8, which is continuous with the sensor elements. The four stress absorption grooves 7 are respectively associated with the four sides of the tetragonal sensor element. Each stress absorption groove 7 is linear and extends straight.
As shown in Fig. 3. the rough adjustment portion 8 is ladder-shaped and includes a plurality of cross bars 9. The rough adjustment portion 8 is trimmed to adjust the resistance of the corresponding one of the magnetic resistors 10 to 40. The rough adjustment portion 8 is arranged between the sensor element and the terminals 10a to 40a of the corresponding one of the magnetic resistors 10 to 40. One of the stress absorption grooves 7 is arranged between the rough adjustment portion 8 and the sensor element. In each of the magnetic resistors 10 to 40, the resistance is adjusted by trimming a certain number of the cross bars 9 in the rough adjustment portion 8. The trimming of the rough adjustment portion 8 may be performed by performing laser trimming, for example.
A method for manufacturing the magnetic sensor 1 will now be discussed with reference to Fig. 4.

First, in a magnetic resistor film formation step S1, the magnetic resistors 10 to 40 are formed on the substrate 2. In the magnetic resistor film formation step S1, the surface of the substrate 2 is oxidized to form the insulative film 3. When the substrate 2 is silicon, the insulative film 3 may be an oxide silicon film. The surface of the insulative film 3 is sputtered to form the four magnetic resistors 10 to 40. The shape, orientation, and location of the four magnetic resistors 10 to 40 are as described above.
Then, in an interlayer insulative film formation step S2, the interlayer insulative film 5 is formed on the substrate 2. The interlayer insulative film 5 is formed on the entire surface of the substrate 2 (insulative film 3) so that the magnetic resistors 10 to 40 are hidden and not exposed.
In a wire formation step S3, the wires 4a to 4f and the metal pads Pa to Pd are formed on the surface of the substrate 2, specifically, the surface of the interlayer insulative film 5. The wires 4a to 4b are electrically connected to the terminals of the magnetic resistors 10 to 40 so that the magnetic resistors 10 to 40 form a bridge circuit.
In a protective film formation step S4. the protective film 6 is formed on the insulative film 3 (and the magnetic resistors 10 to 40). In the protective film formation step S4, the protective film 6 is formed on the entire surface of the interlayer insulative film 5. The protective film 6 may be a nitride film of, for example, silicon nitride. Further, the protective film 6 is formed by performing chemical vapor deposition (CVD).
In a stress absorption groove formation step S5, the stress absorption grooves 7 are formed in the protective film 6. In the stress absorption groove formation step S5, the protective film 6 is etched together with the interlayer insulative film 5 near the magnetic resistors 10 to 40 to form the stress absorption groves 7 in the protective film 6. The substrate 2 on which the protective film 6 with the stress absorption grooves 7 is superimposed is referred to as a multilayer substrate or substrate module 11.
The accuracy of the magnetic sensor 1 increases as a median value of the maximum output Vmax and minimum output Vmin of the detection signal of the magnetic sensor 1, namely, the offset voltage Voff, becomes closer to "0". The magnetic resistors 10 to 40 are formed to approximate the offset voltage Voff to "0" and undergo trimming when necessary. However, residual stress in the protective film 6 causes temporal changes in the offset voltage Voff. By forming the stress absorption grooves 7 in the protective film 6, the residual stress of the protective film 6 is not transmitted to the magnetic resistors 10 to 40. This reduces or prevents temporal changes in the offset voltage Voff and thereby minimizes variations in the offset voltage Voff.
In an annealing step S6 subsequent to the formation of the stress absorption groove 7, the protective film 6 (specifically, the entire substrate module 11) is annealed. In detail, the substrate module 11 is heated to an annealing temperature and kept heated at this temperature for a certain time. Then, the substrate module 11 is slowly cooled. The heating temperature and the heating duration time may be predetermined so as to eliminate strain from the protective film 6. The annealing of the protective film 6 softens the protective film 6 (increases the ductility and tractility) and eliminates internal strain, which was produced when processing and hardening the protective film 6. In this manner, the residual stress of the protective film 6 is reduced or released. Thus, after being formed, deformation and dimensional changes of the protective film 6 are subtle.
In a laser trimming step S7 subsequent to the annealing step S6, the rough adjustment portions 8 of the magnetic resistors 10 to 40 are trimmed to adjust the resistance of the magnetic resistors 10 to 40. In the laser trimming step S7, a laser light is emitted toward a controlled number of the cross bars 9 of one or more selected rough adjustment portions 8 of the magnetic resistors 10 to 40. The laser light trims the cross bars 9 and part of the protective film 6 that covers the cross bars 9. The trimming varies the resistance of the corresponding one of the magnetic resistors 10 to 40 so as to approximate the offset voltage Voff of the magnetic sensor 1 to "0".
In a packaging step SB subsequent to the laser trimming step S7, the substrate module 11 is packaged or covered by a resin. In the packaging step S8, molding is performed to package or cover the entire surface of the substrate module 11 with heated resin and then hardening the resin. The heated resin may be molten resin or liquefied resin, which resins may be solidified by cooling. After sequentially performing the steps described above in that order, the manufacturing of the magnetic sensor 1 is completed.
A plurality of the magnetic sensors 80 of the prior art and a plurality of the magnetic sensors 1 of the preferred embodiment were prepared, and the offset voltage of each magnetic sensor was measured. Fig. 5 shows the distribution range of the offset voltage Voff and an offset voltage average value Vave. The distribution range of the offset voltage Voff was smaller in the magnetic sensors 1 of the preferred embodiment than in the magnetic sensors 80 of the prior art. Further, the average value Vave of the offset voltage Voff was closer to "0" in the magnetic sensors 1 of the preferred embodiment than in the magnetic sensors 80 of the prior art. Thus, the magnetic sensors 1 of the preferred embodiment have a higher capacity and less variations in capacity than the magnetic sensors 80 of the prior art.
In the preferred embodiment, the substrate module 11 including the protective film 6 is annealed (annealing step S6) prior to the laser trimming step S7 and the packaging step S8. This significantly eliminates residual stress of the protective film 6 before the laser trimming step S7 and the packaging step S8 are performed. Thus, even when the protective film 6 is heated in the laser trimming step S7 and the packaging step S8, the heat does not affect the residual stress of the protective film 6 and thereby does not cause variations in the magnetic resistors 10 to 40. Accordingly, even when undergoing the laser trimming step S7 or the packaging step S8, variations in the offset voltage Voff of the magnetic sensor 1 are minimized. When the annealing step S6 is not performed before the packaging step S8, the heat generated in the packaging step would affect the residual stress of a protective film such that the protective film would have a tendency for easily deforming (dimensional change). Such deformation would apply unexpected stress to the magnetic resistor. As a result, temporal changes would occur in the offset voltage of the magnetic sensor and cause variations in the offset voltage.
The preferred embodiment has the advantages described below.
(1) The substrate module 11 is annealed prior to the packaging step S8. This reduces the residual stress of the protective film 6 before the packaging step S8. Thus, even when the substrate module 11 is heated in the packaging step S8, the heat and residual stress of the protective film 6 causes subtle deformation and dimensional changes in the protective film 6. As a result, stress that would vary the resistance of the magnetic resistors 10 to 40 would not be produced in the magnetic resistors 10 to 40. Accordingly, even when the substrate module 11 is heated in the packaging step S8, variations of the offset voltage Voff do not occur in the magnetic sensor 1.
(2) The annealing step S6 is performed prior to the laser trimming step S7 and the packaging step S8. This allows for residual stress to be eliminated from the protective film 6 before the steps S7 and S8 are performed. However, the laser trimming step S7 heats the protective film 6. Residual stress of the protective film 6 is significantly reduced before the laser trimming step S7 heats the protective film 6. Thus, even when the magnetic sensor 1 undergoes the laser trimming step S7 during manufacturing, variations in the offset voltage Voff of the magnetic sensor 1 are subtle.
(3) Subsequent to the annealing step of the substrate module 11, the trimming step is performed. Subsequent to the trimming step, the packaging step is performed. The trimming step finely adjusts the resistances of the magnetic resistors 10 to 40. Further, the annealing step is performed prior to the trimming step. Thus, even when the protective film 6 is heated in the trimming step, variations in the offset voltage Voff are subtle, which would be caused by residual stress in the protective film 6. As a result, the offset voltage Voff, which is finely adjusted in the trimming step, is easily maintained at the desired value for a long period of time.
(4) The magnetic resistors 10 to 40 each include a sensor element repetitively meandered into a zigzagged shaped. This structure allows for accurate detection of the magnetic field for each magnetic resistor.
(5) The magnetic resistors 10 to 40 each include a sensor element repetitively meandered into a zigzagged shaped. Each zigzagged sensor element has a polygonal outer shape that conforms to its polygonal layout region. Each stress absorption groove 7 is a linear groove associated with the straight sides of the corresponding sensor element. This structure allows each stress absorption groove 7 to be as long as possible in a limited space. Thus, residual stress of the protective film 6 is sufficiently eliminated.
(6) The magnetic resistors 10 to 40 each include a sensor element repetitively meandered into a zigzagged shaped. Each zigzagged sensor element has a tetragonal outer shape that conforms to its tetragonal layout region. The four linear stress absorption grooves 7 are respectively associated with the four straight sides of the corresponding sensor element. This structure includes a plurality of the stress absorption grooves 7 for each magnetic resistor and thereby effectively reduces the residual stress of the protective film 6.
(7) The magnetic resistors 10 to 40 each include a sensor element, which is repetitively meandered into a zigzagged shaped, and the rough adjustment portion 8, which is formed at one end of the sensor element. The trimming step partially trims the rough adjustment portion 8. In one example, the rough adjustment portion 8 is ladder-shaped and has the cross bars 9. In the rimming step, a controlled number of the cross bars 9 are selectively trimmed. This structure allows for fine adjustment of the offset voltage Voff.
It should be apparent to those skilled in the art that the present invention may be embodied in many other specific forms without departing from the scope of the invention. Particularly, it should be understood that the present invention may be embodied in the following forms.
The method for manufacturing the magnetic sensor 1 does not necessarily have to include both of the stress absorption groove step S5 and the laser trimming step S7. For example, the laser trimming step S7 may be eliminated as long as the stress absorption groove formation step S5 is included.
The number of bridges in the magnetic sensor 1 is not limited to one, and there may be a plurality of bridges (e.g., two).
The material of the interlayer insulative film 5 and the protective film 6 may be changed as required.
The interlayer insulative film 5 and the protective film 6 may each be a single layer or a multilayer.
The stress absorption grooves 7 are located only around the magnetic resistors 10 to 40, particularly, around the magnetic resistor pattern excluding the rough adjustment portion 8, that is, around the sensor element. However, the stress absorption grooves 7 are not limited to such locations. For example, as shown in Fig. 6, the stress absorption grooves 7 may be arranged around the sensor elements of the magnetic resistors 10 to 40 and around the rough adjustment portions 8.
The four stress absorption grooves 7 are formed in association with the four sides of the tetragonal shape of each magnetic resistor. However, the number of stress absorption grooves 7 for each magnetic resistor is not limited to four. For example, the stress absorption groove 7 may be formed in association with just one of the sides for each of the magnetic resistors 10 to 40.
The stress absorption grooves 7 are not limited to a straight shape and may have other shapes. For example, the stress absorption grooves 7 may be circular or curved.
The stress absorption grooves 7 do not have to be formed through etching and may be formed in other ways.
Laser trimming does not have to be performed on every one of the magnetic resistors 10 to 40. For example, when the preferable value for the offset voltage Voff may be obtained by trimming just the first magnetic resistor 10, the other magnetic resistors 20 to 40 do not have to be trimmed.
Various types of lasers may be used for the laser trimming. For example, IR laser, green laser, or UV laser may be employed.
Various types of cuts may be performed with the laser trimming. For example, a plunge cut, a double plunge cut, an L-cut, or a serpentine cut may be performed.
The magnetic detection elements are not limited to the magnetic resistors 10 to 40. Any element may be used as long as it varies a physical property value in accordance with the detected magnetic field.
The specific contents of the annealing step, for example, the heating duration time or the heating temperature may be set as required.
The present examples and embodiments are to be considered as illustrative and not restrictive, and the intention is not to be limited to the details given herein, but may be modified within the scope and equivalence of the appended claims.

## Claims

1. A method for manufacturing a magnetic sensor (1), the method comprising:
forming a plurality of magnetic detection elements (10, 20, 30, 40) on a substrate (2) to form a bridge circuit;
forming a protective film (6) that covers and protects the magnetic detection elements on the substrate;
forming a plurality of stress absorption grooves (7) in the protective film (6) near each of the magnetic detection elements by etching the protective film (6) to produce a multilayer substrate (11) including the protective film, the stress absorption grooves, and the magnetic detection elements;
packaging the multilayer substrate by forming a packaging mold that covers the entire surface of the multilayer substrate (11) to define the outer shape of the magnetic sensor (1);
the method being **characterized by** further comprising annealing the multilayer substrate prior to the packaging.

2. The method according to claim 1, further comprising:
trimming one or more of the magnetic detection elements subsequent to the annealing but prior to the packaging.

3. The method according to claim 2, wherein the annealing is performed subsequent to the formation of the stress absorption grooves but prior to the trimming.

4. The method according to claim 2, wherein the trimming includes laser trimming that emits laser light to part (9) of the one or more of the magnetic detection elements to remove the part of the one or more of the magnetic detection elements and remove part of the protective film that corresponds to the part of the one or more of the magnetic detection elements.

5. The method according to claim 1, wherein the packaging includes applying heated resin for forming the packaging mold to the multilayer substrate and then hardening the resin.

6. The method according to claim 1, wherein the annealing includes heating the multilayer substrate to a heating temperature and for a heating duration time that are predetermined so as to eliminate strain from the protective film and then slowly cooling the multilayer substrate.

7. A magnetic sensor (1) comprising:
a multilayer substrate (11) including:
a substrate (2);
a bridge circuit formed by a plurality of magnetic detection elements (10, 20, 30, 40) formed on the substrate;
a protective film (6) that covers and protects the magnetic detection elements; and
a plurality of stress absorption grooves (7) formed in the protective film (6) near each of the magnetic detection elements by etching the protective film; and
a packaging mold that covers the entire surface of the multilayer substrate (11) to define the outer shape of the magnetic sensor (1), **characterized in that**
the packaging mold is formed in a packaging step subsequent to formation of the stress absorption grooves, and the multilayer substrate is annealed prior to the packaging step.

## Patentansprüche

1. Verfahren zum Herstellen eines magnetischen Sensors (1), wobei das Verfahren Folgendes umfasst:
Ausbilden mehrerer magnetischer Detektionselemente (10, 20, 30, 40) auf einem Substrat (2) zum Ausbilden einer Brückenschaltung;
Ausbilden eines Schutzfilmes (6), der die magnetischen Detektionselemente auf dem Substrat bedeckt und schützt;
Ausbilden mehrerer Stressabsorptionsnuten (7) in dem Schutzfilm (6) nahe jedem der magnetischen Detektionselemente durch Ätzen des schutzfilmes (6) zum Erzeugen eines mehrschichtigen Substrats (11) einschließlich des Schutzfilms, der Stressabsorptionsnuten und der magnetischen Detektionselemente;
Kapseln des mehrschichtigen Substrats durch Ausbilden eines Kunststoffgehäuses, das die ganze Oberfläche des mehrschichtigen Substrats (11) bedeckt, um die Außengestalt des magnetischen Sensors (1) zu definieren;
wobei das Verfahren **dadurch gekennzeichnet ist, dass** es weiterhin Folgendes umfaßt:
Tempern des mehrschichtigen Substrats vor dem Kapseln.

2. Verfahren nach Anspruch 1, das weiterhin Folgendes umfasst:
Trimmen eines oder mehrerer der magnetischen Detektionselemente nach dem Tempern, aber vor dem Kapseln.

3. verfahren nach Anspruch 2, wobei das Tempern nach der Ausbildung der Stressabsorptionsnuten, vor dem Trimmen, durchgeführt wird.

4. Verfahren nach Anspruch 2, wobei das Trimmen das Lasertrimmen beinhaltet, das Laserlicht an einen Teil (9) des einen oder der mehreren der magnetischen Detektionselemente emittierte um den Teil des einen oder der mehreren der magnetischen Detektionselemente zu entfernen und einen Teil des schutzfilms, der dem Teil des einen oder der mehreren der magnetischen Detektionselemente entspricht, zu entfernen.

5. Verfahren nach Anspruch 1, wobei das Kapseln das Aufbringen erhitzten Harzes zum Ausbilden des Kunststoffgehäuses auf das mehrschichtige Substrat und dann Härten des Harzes beinhaltet.

6. Verfahren nach Anspruch 1, wobei das Tempern das Erhitzen des mehrschichtigen Substrats auf eine Heiztemperatur und für eine Heizdauerzeit beinhaltet, die vorbestimmt sind, um eine Beanspruchung von dem Schutzfilm zu eliminieren, und dann langsames Kühlen des mehrschichtigen Substrats.

7. Magnetischer Sensor (1), der Folgendes umfasst:
ein mehrschichtiges Substrat (11), das Folgendes enthält:
ein Substrat (2);
eine Brückenschaltung, die durch mehrere, auf dem Substrat ausgebildete magnetische Detektionselemente (10, 20, 30, 40) ausgebildet ist;
einen Schutzfilm (6), der die magnetischen Detektionselemente bedeckt und schützt; und
mehrere Stressabsorptionsnuten (7), die in dem Schutzfilm (6) nahe jedem der magnetischen Detektionselemente durch Ätzen des Schutzfilms ausgebildet sind; und
ein Kunststoffgehäuse, das die ganze Oberfläche den mehrschichtigen substrats (11) bedeckt, um die Außengestalt des magnetischen Sensors (1) zu definieren, **dadurch gekennzeichnet, dass** das Kunststoffgehäuse in einem Kapselungsschritt nach der Ausbildung der Stressabsorptionsnuten ausgebildet wird und das mehrschichtige Substrat vor dem Kapselungsschritt getempert wird.

## Revendications

1. Procédé de fabrication d'un capteur magnétique (1), le procédé comprenant les étapes consistant à :
former une pluralité d'éléments de détection magnétiques (10, 20, 30, 40) sur un substrat (2) pour former un circuit en pont ;
former un film protecteur (6) qui recouvre et protège les éléments de détection magnétiques sur le substrat ;
former une pluralité de fentes d'absorption de contraintes (7) dans le film protecteur (6) à proximité de chacun des éléments de détection magnétiques en gravant le film protecteur (6) pour produire un substrat multicouche (11) comprenant le film protecteur, les fentes d'absorption de contraintes et les éléments de détection magnétiques ;
encapsuler le substrat multicouche en formant un moule d'encapsulation qui recouvre l'ensemble de la surface du substrat multicouche (11) pour définir la forme extérieure du capteur magnétique (1) ;
le procédé étant **caractérisé en ce qu'**il comprend en outre l'étape consistant à recuire le substrat multicouche avant l'encapsulation.

2. Procédé selon la revendication 1, comprenant en outre l'étape consistant à :
ajuster un ou plusieurs des éléments de détection magnétiques après le recuit mais avant l'encapsulation.

3. Procédé selon la revendication 2, dans lequel le recuit est effectué après la formation des fentes d'absorption de contraintes mais avant l'ajustement.

4. Procédé selon la revendication 2, dans lequel l'ajustement comprend un ajustement du laser qui émet une lumière laser vers une partie (9) du ou des éléments de détection magnétiques pour retirer la partie du ou des éléments de détection magnétiques et retirer une partie du film protecteur qui correspond à la partie du ou des éléments de détection magnétiques.

5. Procédé selon la revendication 1, dans lequel l'encapsulation comprend les étapes consistant à appliquer une résine chauffé pour former le moule d'encapsulation sur le substrat multicouche puis à faire durcir la résine.

6. Procédé selon la revendication 1, dans lequel le recuit comprend les étapes consistant à chauffer le substrat multicouche à une température de chauffage et pendant une durée de chauffage qui sont déterminées de manière à éviter la déformation du film protecteur, puis à lentement refroidir le substrat multicouche.

7. Capteur magnétique (1) comprenant :
un substrat multicouche (11) comprenant :
un substrat (2) ;
un circuit en pont formé par une pluralité d'éléments de détection magnétiques (10, 20, 30, 40) formés sur le substrat ;
un film protecteur (6) qui recouvre et protège les éléments de détection magnétiques ; et
une pluralité de fentes d'absorption de contraintes (7) formées dans le film protecteur (6) à proximité de chacun des éléments de détection magnétiques en gravant le film protecteur ; et
un moule d'encapsulation qui recouvre l'ensemble de la surface du substrat multicouche (11) pour définir la forme extérieure du capteur magnétique (1), **caractérisé en ce que** le moule d'encapsulation est formé dans une étape d'encapsulation qui suit la formation des fentes d'absorption de contraintes, et le substrat multicouche est recuit avant l'étape d'encapsulation.
